Europäisches Patentamt

European Patent Office

Office européen des brevets

(11) Veröffentlichungsnummer: **0 454 882 A1**

## EUROPÄISCHE PATENTANMELDUNG

(21) Anmeldenummer: 90108326.1

(22) Anmeldetag: 02.05.90

(51) Int. Cl.5: **G06F 7/62**

(43) Veröffentlichungstag der Anmeldung:
06.11.91 Patentblatt 91/45

(84) Benannte Vertragsstaaten:
**CH DE ES FR GB IT LI SE**

(71) Anmelder: **SIEMENS AKTIENGESELLSCHAFT**
**Wittelsbacherplatz 2**
**W-8000 München 2(DE)**

(72) Erfinder: **Brune, Richard, Dipl.-Ing.**
**Sonneberger Strasse 38**
**W-8510 Fürth(DE)**

(54) **Digitale Zählschaltung.**

(57) Digitale Zählschaltung zur Auswertung eines digitalen Signals ($S_S$) mit einem digitalen Zähler (Z), wobei das digitale Signal ($S_S$) mit dem der Eingang (ZE) des Zählers (Z) beaufschlagt ist, als eine weitere Binärstelle darstellendes Ausgangssignal (N + 1), zu den Ausgangssignalen (N) des Zählers (Z) verwendet wird.

FIG 1

EP 0 454 882 A1

Die Erfindung betrifft eine digitale Zählschaltung zur Auswertung eines digitalen Signals unter Verwendung eines digitalen Zählers.

Digitale Zähler sind beispielsweise aus U.Tietze, Ch.Schenk, "Halbleiterschaltungstechnik", 6. Auflage, Springer Verlag Berlin, S. 247 ff bekannt. Diese digitalen Zähler arbeiten gewöhnlich nach dem Prinzip der Frequenzteilung, das mit Hilfe von Flip-Flop-Schaltungen realisiert wird. Jeder binäre Ausgang des Zählers steht dabei in einem festen Teilungsverhältnis zur Frequenz des digitalen Signals, das auf den Zählereingang gegeben wird. Die Frequenz der niederwertigsten Binärstelle ist bei den bekannten Zählern halb so groß wie die Frequenz des digitalen Eingangssignals dessen Pulse gezählt werden. Zur Erhöhung des Zählbereichs muß jeweils auf einen Zähler mit mehreren Binärstellen zurückgegriffen werden.

Aufgabe der Erfindung ist es, eine digitale Zählschaltung zu erhalten, mit der der Zählbereich von gegebenen Zählern erhöht wird.

Diese Aufgabe wird dadurch gelöst, daß das digitale Signal mit dem der Eingang des Zählers beaufschlagt ist, als eine weitere Binärstelle darstellendes Ausgangssignal zu den Ausgangssignalen des Zählers verwendet wird.

Vorteilhafte Ausgestaltungen der Erfindung sind Gegenstand der Unteransprüche.

Ein Ausführungbeispiel der Erfindung ist in der Zeichnung dargestellt und wird im folgenden näher erläutert. Dabei zeigen:

FIG 1 eine digitale Zählschaltung,
FIG 2 bis FIG 6 Impulsdiagramme,
FIG 7 den Inhalt eines Zählregisters.

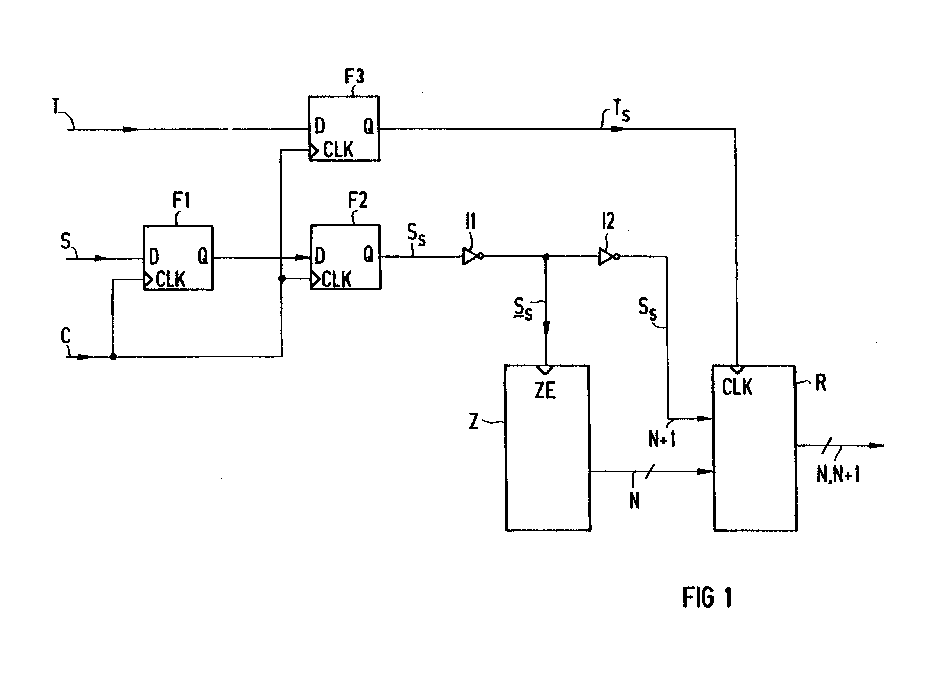

FIG 1 zeigt eine digitale Zählschaltung, die aus drei D-Flip-Flops F1, F2, F3, zwei Invertern I1, I2, einem Zähler Z sowie einem Register R besteht. Die Richtung des Signalsflusses der untereinander verbundenen Bauteile ist jeweils durch Pfeile dargestellt.

Am Eingang D des ersten Flip-Flops F1 wird ein digitales Signal S angelegt, dessen Impulse innerhalb einer bestimmten Zeit gezählt werden sollen. Das digitale Signal S soll dabei ein Pulspausenverhältnis von 1 : 1 aufweisen. An den Takteingang CLK des ersten sowie den Takteingang CLK des zweiten Flip-Flops F2 wird ein erstes Taktsignal C gegeben. Das erste Taktsignal C erfüllt bezüglich des digitalen Signals S das Abtasttheorem, d.h. die Frequenz des ersten Taktsignals C ist größer als die doppelte maximale Frequenz des digitalen Signals S. Durch die beiden in Serie geschalteten D-Flip-Flops und das erste Taktsignal C wird erreicht, daß am Ausgang des zweiten Flip-Flops F2 das digitale Signal S als synchronisiertes Signal $S_S$ anliegt, d.h. die positive Flanke des synchronen Signals $S_S$ hat einen festen Bezug zur positiven Flanke des ersten Taktsignals C.

Das synchrone Signal $S_S$ am Ausgang Q des zweiten Flip-Flops F2 wird durch den Inverter I1 invertiert und als invertiertes synchrones Signal $\overline{S_S}$ auf den Zählereingang ZE gegeben. Im dargestellten Ausführungsbeispiel wird durch den Inverter I1 eine Laufzeitverzögerung des synchronisierten Signals $S_S$ erreicht, so daß die Ausgangssignale N des Zählers Z zum richtigen Zeitpunkt für das Register R zur Verfügung stehen. Der Zähler Z hat eine Genauigkeit von N-Binärstellen, wobei die niederwertigste Binärstelle also die N-te Binärstelle der halben Frequenz des synchronen Signals $S_S$ entspricht. Zur Erhöhung des Zählbereichs wird deshalb das synchrone Signal $S_S$ als N+1-te Binärstelle des Zählers verwendet. Im vorliegenden Ausführungsbeispiel wird dazu das invertierte synchrone Signal $\overline{S_S}$ durch einen weiteren Inverter I2 invertiert. Die Invertierung könnte aber beispielsweise auch softwaremäßig erfolgen. Als Zählsignale werden also die N-Ausgangssignale des Zählers und als N+1-tes Signal das synchrone digitale Signal $S_S$ verwendet, wobei das N+1-te Signal nunmehr die niederwertigste Binärstelle darstellt.

Die Zählerausgangssignale N, N+1 werden im Ausführungsbeispiel an ein Datenregister R gegeben, das den Zählerstand zu vorgebbaren Zeitpunkten übernimmt. Zur Vermeidung metastabiler Zustände wird das Datenregister R mit einem synchronen Taktsignal $T_S$ getaktet, wobei das synchrone Taktsignal $T_S$ aus dem Taktsignal T durch Synchronisation mit dem ersten Taktsignal C über ein drittes Flip-Flop F3 erfolgt.

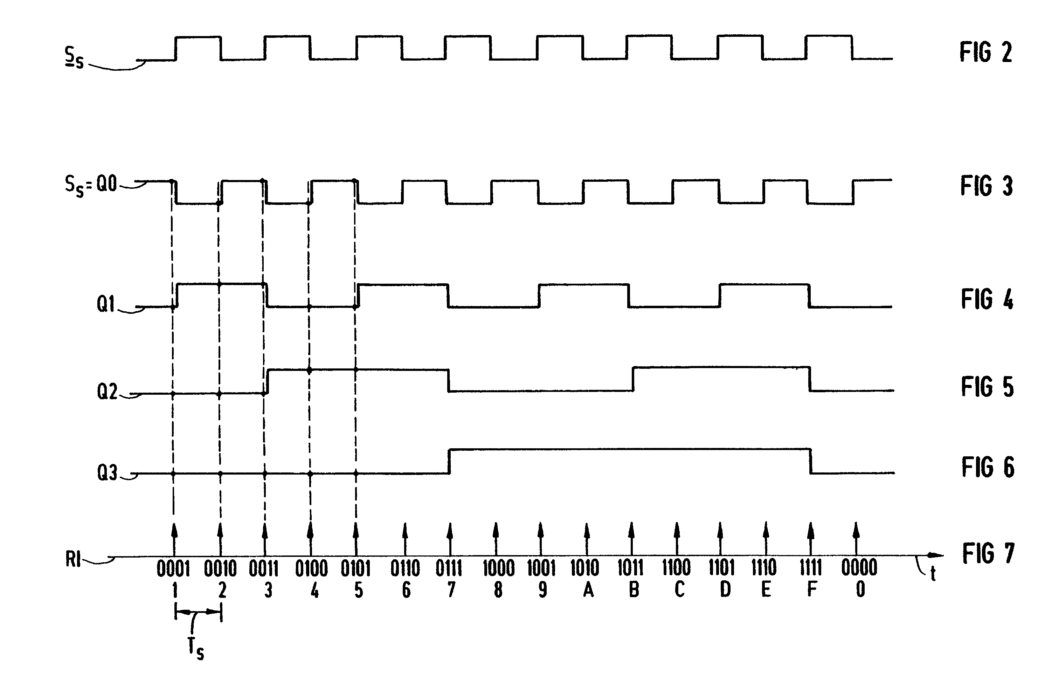

Die Figuren 2 bis 6 zeigen Impulsdiagramme die die Arbeitsweise der Zählschaltung verdeutlichen sollen. In FIG 7 ist der Zeitbezug zu den Impulsdiagrammen dargestellt. Das Impulsdiagramm des invertierten synchronisierten Signals $\overline{S_S}$ mit dem der Zählereingang ZE, FIG 1, beaufschlagt wird, ist in FIG 2 dargestellt. Es wird angenommen, daß der aus FIG 1 bekannte Zähler Z über drei binäre Ausgänge Q1, Q2, Q3 verfügt. Die Impulsdiagramme dieser drei binären Zählerausgänge Q1, Q2, Q3 sind in den Figuren 4, 5 und 6 dargestellt. Die höchstwertigste Binärstelle ist am Zählerausgang Q3, die niederwertigste Binärstelle am Zählerausgang Q1 abgreifbar. Mit diesem Zähler könnten lediglich $2^3$ verschiedene Ausgangszustände erreicht, also binär nur bis acht gezählt werden. Wird nun wie in FIG 3 dargestellt, das synchronisierte Signal $S_S$ als niederwertigstes binäres Ausgangssignal Q0 zu den Zählerausgangssignalen Q1, Q2, Q3 hinzugenommen, so erhält man vier binäre Ausgangssignale, so daß ein Zählbereich von $2^4$ erreicht wird.

Werden die binären Signale Q0, Q1, Q2, Q3 in das Register R im vorgegebenen synchronisierten Taktsignal $T_S$ übernommen, so ergibt sich der in FIG 7 binär und hexadezimal dargestellte Registerinhalt RI.

**Patentansprüche**

1. Digitale Zählschaltung zur Auswertung eines digitalen Signals ($S_S$) mit einem digitalen Zähler (Z), **dadurch gekennzeichnet,** daß das digitale Signal ($S_S$) mit dem der Eingang (ZE) des Zählers (Z) beaufschlagt ist, als eine weitere Binärstelle darstellendes Ausgangssignal (N + 1) zu den Ausgangssignalen (N) des Zählers (Z) verwendet wird.

2. Digitale Zählschaltung nach Anspruch 1, **dadurch gekennzeichnet,** daß das digitale Signal ($S_S$) durch Synchronisation eines digitalen Frequenzsignals (S) zu einem ersten Taktsignal (C) gewonnen wird.

3. Digitale Zählschaltung nach Anspruch 2, **dadurch gekennzeichnet,** daß das digitale Frequenzsignal (S) durch zwei in Serie geschaltete D-Flip-Flops (F1, F2) synchronisiert wird, deren Takteingang (CLK) mit einem ersten Taktsignal (C) gespeist wird, das bezüglich des digitalen Frequenzsignals ($S_S$) das Abtasttheorem erfüllt.

4. Digitale Zählschaltung nach einem der vorstehenden Ansprüche, **dadurch gekennzeichnet,** daß die Zählerausgangssignale (n,n + 1) in ein Datenregister (R) übernommen werden.

5. Digitale Zählschaltung nach Anspruch 4, **dadurch gekennzeichnet,** daß das Datenregister (R) mit einem bezüglich des ersten Taktsignals (C) synchronisierten Taktsignals ($T_S$) getaktet wird.

6. Digitale Zählschaltung nach einem der vorstehenden Ansprüche, **dadurch gekennzeichnet,** daß das zusätzliche Ausgangssignal (N + 1) invertiert wird.

FIG 1

EP 0 454 882 A1

EP 0 454 882 A1

FIG 2

FIG 3

FIG 4

FIG 5

FIG 6

FIG 7

$S_S$

$S_S = Q0$

$Q1$

$Q2$

$Q3$

RI

| 0001 | 0010 | 0011 | 0100 | 0101 | 0110 | 0111 | 1000 | 1001 | 1010 | 1011 | 1100 | 1101 | 1110 | 1111 | 0000 |
| 1 | 2 | 3 | 4 | 5 | 6 | 7 | 8 | 9 | A | B | C | D | E | F | 0 |

$T_S$

$t$

**Europäisches Patentamt**

# EUROPÄISCHER RECHERCHENBERICHT

Nummer der Anmeldung

## EP 90 10 8326

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-2 404 696 (MESSERSCHMITT-BÖLKOW-BLOHM) * Fig.; Seite 5, Zeilen 9-11 * — — — | 1 | G 06 F 7/62 |
| A | ELECTRONICS, Band 52, Nr. 18, August 1979, Seite 140; B. ALBING: "C-MOS counter-decoder pair sets divider's modulus" — — — — — | 1 | |

**RECHERCHIERTE SACHGEBIETE (Int. Cl.5)**

G 06 F
H 03 K

Der vorliegende Recherchenbericht wurde für alle Patentansprüche erstellt

| Recherchenort | Abschlußdatum der Recherche | Prüfer |
|---|---|---|
| Den Haag | 19 Dezember 90 | FEUER F.S. |